Europäisches Patentamt

European Patent Office

Office européen des brevets

(19)

(11) Veröffentlichungsnummer **0 041 132**
**B1**

(12) # EUROPÄISCHE PATENTSCHRIFT

(45) Veröffentlichungstag der Patentschrift:
08.08.84

(51) Int. Cl.³: **H 03 K 17/60, G 08 B 13/00**

(21) Anmeldenummer: **81103277.0**

(22) Anmeldetag: **30.04.81**

(54) **Ausgangsstufe für ein elektrisches Ausgangssignal abgebende Sensoren.**

(30) Priorität: **02.06.80 DE 3020885**

(43) Veröffentlichungstag der Anmeldung:
**09.12.81 Patentblatt 81/49**

(45) Bekanntmachung des Hinweises auf die Patenterteilung:
**08.08.84 Patentblatt 84/32**

(84) Benannte Vertragsstaaten:
**BE CH FR GB IT LI**

(56) Entgegenhaltungen:
**DE - A - 2 529 866**
**US - A - 3 509 359**
**US - A - 3 654 490**

(73) Patentinhaber: **Erwin Sick GmbH Optik-Elektronik,
Sebastian-Kneipp-Strasse 1, D-7808 Waldkirch (DE)**

(72) Erfinder: **Erdmann, Jürgen, Eisenbahnstrasse 35,
D-7808 Waldkirch 3 (DE)**
Erfinder: **Herzer, Gerhard, Ziegelhof 36,
D-7830 Emmendingen (DE)**
Erfinder: **Walter, Arthur, Dr., Im Buchengrün 5,
D-7808 Waldkirch (DE)**

(74) Vertreter: **Dipl.-Phys.Dr. Manitz Dipl.-Ing. Finsterwald
Dipl.-Ing. Grämkow Dipl.-Chem.Dr. Heyn
Dipl.-Phys.Rotermund Morgan B.Sc.(Phys.),
Robert-Koch-Strasse 1, D-8000 München 22 (DE)**

**Beschreibung**

Die Erfindung betrifft eine Ausgangsstufe für ein elektrisches Ausgangssignal abgebende Sensoren mit einem PNP- und einem NPN-Transistor, deren Basen parallel vom Sensorausgang gespeist sind und deren Emitter an den positiven bzw. negativen, jeweils eine Ausgangsklemme bildenden Pol der Speisegleichspannung angelegt sind.

Bei den Sensoren kann es sich um magnetisch, induktiv, kapazitiv, mit Ultraschall, Mikrowellen oder Infrarot- bzw. sichtbarem Licht arbeitende Sensoren handeln, welche in Abhängigkeit von irgendeiner Eingangsgröße, beispielsweise einer Lichtintensität ein entsprechendes elektrisches Ausgangssignal abgeben. Derartige Sensoren weisen einen das elektrische Signal abgebenden Schaltausgang auf, welcher an nachfolgende, das elektrische Ausgangssignal verarbeitende Einrichtungen angeschlossen ist. Im allgemeinen handelt es sich bei dem elektrischen Ausgangssignal lediglich um ein Ja-Nein-Signal, welches bevorzugt als positive bzw. negative Gleichspannung dargestellt wird. Insbesondere befaßt sich die Erfindung mit dem Schaltausgang von photoelektronischen Geräten, z. B. Lichtschranken, Lichttastern, Lichtvorhängen usw.

Es sind bereits zahlreiche Ausgangsstufen für derartige Sensoren bekannt, z. B. NPN- und PNP-Transistor-Ausgangsstufen. Auch ist es bereits bekannt, einen PNP- und einen NPN-Transistor in einer Gegentakt-Schaltstufe derart zusammenzuschalten, daß der Sensor die beiden Transistoren gegenphasig schaltet. Eine derartige Komplementärschaltstufe hat den Vorteil, daß der Ausgang in jedem Schaltzustand niederohmig ist, da entweder der PNP- oder der NPN-Transistor leitet, während bei einem einfachen NPN- bzw. PNP-Ausgang der Ausgangswiderstand im Kollektorkreis in der Größenordnung von einigen Kiloohm maßgebend ist, wenn der zugeordnete Transistor sperrt. Das bedeutet in der Praxis vor allem beim Einsatz in der Industrie, daß die Gefahr der Beeinflussung durch Störspannungen beim Gegentaktausgang geringer ist. Bei einer in die Steuerleitung eingespeisten Störleistung ist die auftretende Störspannung um so niedriger, je kleiner der Lastwiderstand ist.

In der industriellen Steuerungstechnik werden in zunehmendem Maße Relais und Schaltschütze durch elektronische Logikbausteine ersetzt. Dabei hat sich als Standard die Positiv-Logik durchgesetzt, bei der beim Anlegen einer positiven Eingangsspannung der Logikbaustein angesteuert wird. Hierfür ist am Ausgang des an den Logikbaustein anzuschließenden Sensors ein PNP-Transistorausgang erforderlich.

Des weiteren sind bei modernen Steuerungen Prüfprogramme vorgesehen, mit denen die ordnungsgemäße Funktion der Steuerungslogik getestet werden kann. Hierzu wird das Ausgangssignal des Sensors (bzw. das Eingangssignal am Logikbaustein) simuliert, derart, daß der betref

fende Logikeingang niederohmig mit dem Logiksignal »Niedrig« oder »Hoch« beaufschlagt wird, und zwar ohne Rücksicht auf den Schaltzustand des angeschlossenen Sensorausgangs. Ein einfacher Sensorschaltausgang der bekannten Art würde in diesem Fall überlastet und hätte möglicherweise den Geräteausfall zur Folge. Sensorausgänge für derartige Steuerungen haben deshalb eine Strombegrenzung, welche den maximalen Strom im Ausgang auf unkritische Werte in der Größenordnung von 5 bis 10 mA begrenzen. Mit einem derartigen Ausgang kann aber kein gewöhnliches Industrierelais geschaltet werden, dessen Ansprechleistung in der Größenordnung von 0,5 W liegt.

Das Ziel der Erfindung besteht somit darin, eine Ausgangsstufe für ein elektrisches Ausgangssignal abgebende Sensoren der eingangs genannten Gattung zu schaffen, welche von vornherein für eine große Vielzahl praktischer Einsatzfälle ausgelegt ist, das heißt die Betriebsmöglichkeiten nach den erwähnten bekannten Schaltungen beinhaltet, ohne deren Nachteile aufzuweisen und einen komplizierten Aufbau aufzuweisen.

Zur Lösung dieser Aufgabe sieht die Erfindung vor, daß die Kollektoren der beiden Transistoren über Schaltmittel miteinander verbindbar sind, jeweils über einen Ausgangswiderstand mit dem positiven bzw. negativen Pol der Speisespannung und mit einer Ausgangsklemme verbunden sind.

Auf diese Weise steht an der Ausgangsstufe sowohl ein NPN- als auch PNP-Transistorausgang zur Verfügung, während gleichzeitig durch Verbinden der beiden Kollektoren ein Gegentaktausgang mit dem Vorteil der verbesserten Störsicherheit geschaffen werden kann. Die erfindungsgemäße Ausgangsstufe ermöglicht somit eine optimale Anpassung an alle praktischen Einsatzmöglichkeiten eines derartigen Sensors.

Von besonderem Vorteil ist es, wenn der Kollektor des NPN-Transistors zusätzlich über einen Schutzwiderstand an einen weiteren Ausgang angeschlossen ist. Vorzugsweise soll auch der Kollektor des PNP-Transistors zusätzlich über einen Schutzwiderstand an einen weiteren Ausgang angeschlossen sein. Der Schutzwiderstand ist so dimensioniert, daß einerseits mit diesen Ausgängen nachfolgende elektronische Steuerbausteine sicher angesteuert werden können, andererseits aber beim Anlegen eines Testsignals von außen, insbesondere eines Kurzschlusses des Ausgangs mit dem positiven oder negativen Pol der Versorgungsspannung keine Überlastung auftritt.

Die Umschaltung auf Gegentaktbetrieb kann vorteilhafterweise dadurch erfolgen, daß die Kollektoren der Transistoren durch einen Schalter miteinander verbunden sind. Es ist aber auch denkbar, die beiden von den Kollektoren abzweigenden Ausgangsklemmen durch geeignete Schaltmittel miteinander zu verbinden

Die Transistoren können gegen Überspannungen dadurch geschützt werden, daß die Emitter-Kollektorstrecken der beiden Transistoren durch Zener-Dioden gegen Überspannung gesichert sind.

Um Zerstörungen bei falsch gepolter Versorgungsspannung insbesondere im Gegentaktbetrieb auszuschließen, ist nach einer weiteren vorteilhaften Ausführungsform der Erfindung vorgesehen, daß zwischen dem Kollektor und die zugeordnete Ausgangsklemme eines/oder beider Transistoren eine in Durchlaßrichtung gepolte Diode geschaltet ist.

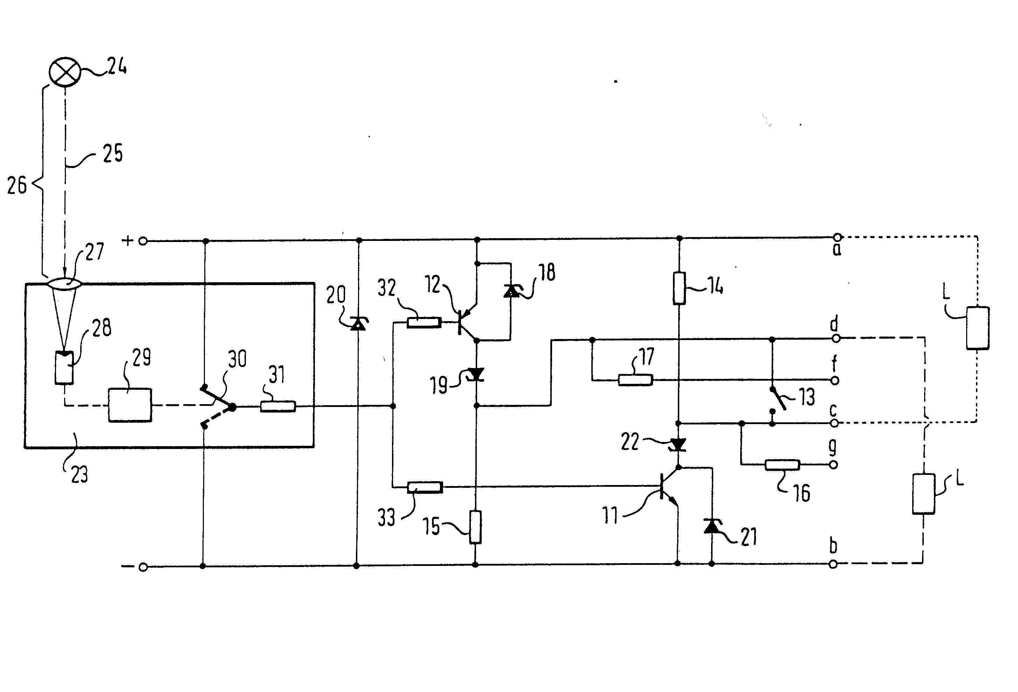

Die Erfindung wird im folgenden beispielsweise beschrieben, deren einzige Figur ein schematisches Schaltbild einer erfindungsgemäßen Ausgangsstufe für ein elektrisches Ausgangssignal abgebende Sensoren zeigt, wobei der Sensor die Lichtempfangsvorrichtung einer Lichtschranke ist.

Nach der Zeichnung ist der Sensor 23 beispielsweise als Lichtempfangsvorrichtung einer Lichtschranke ausgebildet, welche eine Lichtquelle 24 aufweist, die einen gebündelten Lichtstrahl 25 über eine zu überwachende Wegstrecke 26 schickt. Der Lichtstrahl 25 wird von einer im Sensor 23 angeordneten Frontlinse 27 empfangen und auf einem photoelektrischen Wandler 28 konzentriert. Der photoelektrische Wandler 28 ist an eine elektronische Schaltung 29 angeschlossen, welche Verstärker und Schwellenwert-Bauelemente enthält und einen vorzugsweise elektronischen Schalter 30 entweder an eine positive oder eine negative Gleichspannung von beispielsweise plus oder minus 9 V anschließt. In der Darstellung der Zeichnung liegt der Schalter 30 gerade an der positiven Gleichspannung. In der anderen möglichen Schaltstellung, welche gestrichelt angedeutet ist, befindet sich der Schaltarm an der negativen Gleichspannung.

Die in der Zeichnung in ausgezogenen Linien dargestellte Position des Schalters 30 entspricht beispielsweise einer nicht unterbrochenen Überwachungsstrecke 26. Tritt ein Hindernis in die Überwachungsstrecke 26 ein, so wird der Lichtstrahl 25 unterbrochen und der Schalter 30 gelangt in die gestrichelt dargestellte Position.

Über einen Widerstand 31 ist die vom Schalter 30 abgenommene positive oder negative Gleichspannung an die beiden Basen eines NPN-Transistors 11 bzw. eines PNP-Transistors 12 angelegt. Zwischen den durch den Innenwiderstand 31 gebildeten unmittelbaren Ausgang des Sensors 23 und die Basen der Transistoren 11, 12 müssen noch elektronische Bauelemente eingeschaltet werden, welche verhindern, daß zwischen dem Plus- und dem Minuspol der Versorgungsspannung über die Basen der beiden Transistoren 11, 12 ein Kurzschluß vorliegt. Im vorliegenden Ausführungsbeispiel sind zu diesem Zweck Widerstände 32, 33 in jeden Basiskreis eingeschaltet, welche groß gegen den Widerstand 31 sind. Hierdurch wird auch gewährleistet, daß zu jedem Zeitpunkt jeweils nur einer der Transistoren 11, 12 leitend ist. Es ist aber auch möglich, beispielsweise schaltende oder verstärkende Transistoren zwischenzuschalten. Wesentlich ist jedoch, daß die Basen der beiden Transistoren 11, 12 der Stellung des Schalters 30 entsprechende gleichgeartete Signale erhalten.

Der NPN-Transistor 11 ist mit seinem Emitter unmittelbar an den negativen Pol der Versorgungsspannung angeschlossen, während der Kollektor über eine in Durchlaßrichtung gepolte Diode 22 und einen Widerstand 14 in der Größenordnung von einigen Kiloohm am positiven Pol der Versorgungsspannung anliegt.

Entsprechend ist der Emitter des PNP-Transistors unmittelbar an den positiven Pol der Versorgungsgleichspannung angelegt, während der Kollektor des Transistors 12 über eine in Durchlaßrichtung gepolte Diode 19 und einen Widerstand 15 in der Größenordnung von einigen Kiloohm an dem negativen Pol der Gleichspannung anliegt.

Die Emitter-Kollektorstrecken beider Transistoren 11, 12 sind durch Zener-Dioden 18 bzw. 21 gegen Überspannungen geschützt. Zwischen die beiden Pole der Versorgungsgleichspannung ist außerdem zum Schutz gegen Überspannungen eine Zener-Diode 20 geschaltet.

Erfindungsgemäß bilden der positive Pol und der negative Pol der Versorgungsgleichspannung jeweils eine Ausgangsklemme a bzw. b der Ausgangsstufe. Eine weitere Ausgangsklemme c ist über die in Durchlaßrichtung gepolte Schutzdiode 22 an den Kollektor des NPN-Transistors 11 angeschlossen. Über die Diode 22 und einen Schutzwiderstand 16 ist der Kollektor des Transistors 11 außerdem an eine weitere Ausgangsklemme g angelegt.

Der Kollektor des NPN-Transistors 12 ist über die in Durchlaßrichtung gepolte Schutzdiode 19 an eine weitere Ausgangsklemme d angelegt. Der Kollektor ist über die Schutzdiode 19 und einen weiteren Schutzwiderstand 17 außerdem an eine sechste Ausgangsklemme f angeschlossen.

Die Schutzwiderstände 16, 17 sind so dimensioniert, daß einerseits den Ausgängen f, g nachfolgende elektronische Steuerbausteine sicher angesteuert werden können, andererseits aber beim Anlegen eines Testsignals von außen, insbesondere einem Kurzschluß der Ausgangsklemmen f, g mit dem positiven oder negativen Pol der Versorgungsgleichspannung keine Überlastung der Transistoren 11 bzw. 12 auftritt.

Die Ausgangsklemmen c, d sind durch einen Schalter 13 oder eine steckbare Brücke 13 verbunden, welcher im geschlossenen Zustand die Kollektoren der Transistoren 11, 12 über die Schutzdioden 19, 22 miteinander verbindet und so eine Gegentakt-Ausgangsstufe schafft. Von den beiden Schutzdioden 19, 22 ist nur eine erforderlich, um die Schaltung im Gegentaktbetrieb vor Zerstörung bei falsch gepolter Versorgungsgleichspannung zu schützen.

In gestrichelten bzw. punktierten Linien sind die verschiedenen Anschlußmöglichkeiten eines Verbrauchers L an die erfindungsgemäße Ausgangsstufe angedeutet.

Eine erste Anschlußmöglichkeit besteht darin, daß an die Klemmen a und c über die punktiert angedeutete Verbindung ein Verbraucher L angeschlossen wird. Dieser Anschluß entspricht einer NPN-Transistorausgangsstufe mit dem NPN-Transistor 11. Der Verbraucher L kann ein elektro-mechanisches Schaltglied wie z. B. ein Industrierelais, ein Magnetventil oder ein Zähler sein, wobei die Schaltströme in der Größenordnung von 0,1 bis 1 A liegen können. Wesentlich ist, daß die elektro-mechanischen Schaltglieder in Steuerungen mit gemeinsamer Plus-Versorgungsschiene liegen. Durch den punktiert angedeuteten Anschluß ist also das direkte Ansteuern von elektro-mechanischen Schaltgliedern in Steuerungen mit gemeinsamer Plus-Versorgungsschiene möglich.

Die Anschlußklemmen a, c können auch für eine »wired« bzw. verdrahtete ODER-Verknüpfung in einer Negativlogik durch Parallelschalten von Schaltstufen herangezogen werden.

Wird der Verbraucher L in der in gestrichelten Linien angedeuteten Weise an die Ausgangsklemmen b, d angelegt, so entspricht dies einem PNP-Transistorausgang mit dem PNP-Transistor 12.

Der Verbraucher L ist jetzt wieder ein elektromechanisches Schaltglied mit einem Schaltstrom in der Größenordnung von 0,1 bis 1 A, wobei jedoch eine Steuerung mit gemeinsamer Minus-Versorgungsschiene vorliegt. Die Ausgangsklemmen b, d ermöglichen also ein direktes Ansteuern von elektro-mechanischen Schaltgliedern in Steuerungen mit gemeinsamer Minus-Versorgungsschiene.

Außerdem ermöglichen die beiden Anschlußklemmen b, d eine einfache »wired« oder verdrahtete ODER-Verknüpfung in einer Positivlogik durch Parallelschalten von Schaltstufen.

Über die Klemmen b/f und g/a kann der Anschluß an Steuereinrichtungen mit einem Testprogramm erfolgen, wobei die Schutzwiderstände 16, 17 eine Beschädigung oder Zerstörung der Transistoren 11, 12 auch dann verhindern, wenn es während des Testprogrammes praktisch zu einem Kurzschluß zwischen den Klemmen a/f oder b/f bzw. a/g oder g/b kommen sollte.

Bei geschlossenem Schalter 13 kann schließlich der Verbraucher L gemäß der punktierten bzw. gestrichelten Darstellung angeschlossen werden. Es liegt jetzt ein Gegentakt-Ausgang mit dem Vorteil der verbesserten Störsicherheit vor. Die Dimensionierung der einzelnen Bauelemente ist — wie bereits beschrieben — so, daß der Sensorschalter 30 den NPN-Transistor 11 und den PNP-Transistor 12 gegenphasig schaltet. Diese Komplementär-Schaltstufe hat den Vorteil, daß der Ausgang in jedem Schaltzustand niederohmig ist, da entweder der PNP-Transistor 12 oder der NPN-Transistor 11 leitet. Hierdurch wird die Gefahr einer Beeinflussung durch Störspannungen herabgesetzt. Bei einer in die Steuerleitung eingespeisten Störleistung ist die auftretende Störspannung um so niedriger, je kleiner der Abschlußwiderstand ist.

Der Abschlußwiderstand ergibt sich beim Vorliegen des Gegentakt-Ausganges aus der Parallelschaltung des Verbrauchers L mit dem Innenwiderstand des durchgeschalteten Transistors 11 bzw. 12.

Wesentlich für die Erfindung ist also, daß die einzelnen Schaltelemente so dimensioniert sind, daß in der einen Schaltstellung des Schalters 30 des Sensors 23 der eine Transistor, beispielsweise der NPN-Transistor 11 leitet, der andere nicht, während im anderen Schaltzustand des Schalters 30 der andere Transistor, beispielsweise der PNP-Transistor 12 leitet, der eine (beispielsweise der NPN-Transistor 11) dagegen nicht. Nur aufgrund dieser Arbeitsweise ist es möglich, beide Ausgänge durch Parallelschalten zu einem Gegentaktausgang zu vereinigen.

Der Erfindung liegt die Erkenntnis zugrunde, daß die Kollektorwiderstände 14, 15 bei einer unmittelbaren Verbindung der Kollektoren praktisch unwirksam werden, so daß allein durch eine einzige Schaltungsmaßnahme, nämlich die Verbindung der Kollektoren zu den beiden Grundschaltungsanordnungen eine weitere Schaltungsanordnung verwirklicht werden kann.

## Patentansprüche

1. Ausgangsstufe für ein elektrisches Ausgangssignal abgebende Sensoren mit einem PNP- und einem NPN-Transistor, deren Basen parallel vom Sensorausgang gespeist sind und deren Emitter an den positiven bzw. negativen, jeweils eine Ausgangsklemme bildenden Pol der Speisegleichspannung angelegt sind, dadurch gekennzeichnet, daß die Kollektoren der beiden Transistoren (11, 12) über Schaltmittel (13) miteinander verbindbar sind, jeweils über einen Ausgangswiderstand (14, 15) mit dem positiven bzw. negativen Pol der Speisespannung und jeweils mit einer Ausgangsklemme (c, d) verbunden sind.

2. Ausgangsstufe nach Anspruch 1, dadurch gekennzeichnet, daß der Kollektor des NPN-Transistors (11) zusätzlich über einen Schutzwiderstand (16) an einen weiteren Ausgang (g) angeschlossen ist.

3. Ausgangsstufe nach Anspruch 1 oder 2, dadurch gekennzeichnet, daß der Kollektor des PNP-Transistors (12) zusätzlich über einen Schutzwiderstand (17) an einen weiteren Ausgang (f) angeschlossen ist.

4. Ausgangsstufe nach einem der vorhergehenden Ansprüche, dadurch gekennzeichnet, daß die Schaltmittel (13) einen Schalter darstellen.

5. Ausgangsstufe nach einem der vorhergehenden Ansprüche, dadurch gekennzeichnet, daß die Emitter-Kollektorstrecken der beiden Transistoren (11, 12) durch Zener-Dioden (18, 21) gegen Überspannung gesichert sind.

6. Ausgangsstufe nach einem der vorhergehenden Ansprüche, dadurch gekennzeichnet, daß zwischen den Kollektor und die zugeordnete Ausgangsklemme (c, d) eines oder beider Transistoren (11, 12) eine in Durchlaßrichtung gepolte Diode (19, 22) geschaltet ist.

**Claims**

1. Output stage for sensors which transmit an electrical output signal, the output stage having a PNP and an NPN transistor the bases of which are fed in parallel from the sensor output and the emitters of which are respectively connected to the positive and negative terminals of the feed voltage, each of which form an output terminal, characterised in that the collectors of the two transistors (11, 12) are connectable with one another via circuit means (13), are each connected via an output resistor (14, 15) with the positive and negative terminals of the feed voltage respectively, and are each connected with one output terminal (c, d).

2. Output stage in accordance with claim 1, characterised in that the collector of the NPN transistor (11) is additionally connected to a further output (g) via a protective resistor (16).

3. Output stage in accordance with claim 1 or claim 2, characterised in that the collector of the PNP transistor (12) is additionally connected to a further output (f) via a protective resistor (17).

4. Output stage in accordance with one of the preceding claims, characterised in that the circuit means (13) comprises a switch.

5. Output stage in accordance with one of the preceding claims, characterised in that the emitter and collector junctions of the two transistors (11, 12) are protected by Zener diodes (18, 21) against over-voltage.

6. Output stage in accordance with one of the preceding claims, characterised in that a diode (19, 22) is inserted between the collector and the associated output terminal (c, d) of one or both transistors (11, 12) and is poled in the forward direction.

**Revendications**

1. Etage de sortie pour capteurs délivrant un signal électrique, comprenant un transistor PNP et un transistor NPN dont les bases sont alimentées parallèlement par rapport à la sortie des capteurs et dont les émetteurs sont branchés sur le pôle positif ou négatif, formant respectivement une borne de sortie, de la tension continue d'alimentation, caractérisé en ce que les collecteurs des deux transistors (11, 12) peuvent être reliés entre eux par l'intermédiaire de moyens de commutation (13), et sont reliés, respectivement, par une résistance de sortie (14, 15) au pôle positif ou négatif de la tension d'alimentation et, respectivement, à une borne de sortie (c, d).

2. Etage de sortie selon la revendication 1, caractérisé en ce que le collecteur du transistor NPN (11) est raccordé additionnellement par l'intermédiaire d'une résistance de protection (16) à une autre sortie (g).

3. Etage de sortie selon la revendication 1 ou la revendication 2, caractérisé en ce que le collecteur du transistor PNP (12) est raccordé additionnellement par une résistance de protection (17) à une autre sortie (f).

4. Etage de sortie selon l'une des revendications précédentes, caractérisé en ce que les moyens de commutation (13) constituent un commutateur.

5. Etage de sortie selon l'une des revendications précédentes, caractérisé en ce que les trajets émetteurs-collecteurs des deux transistors (11, 12) sont garantis contre une surtension par des diodes Zener (18, 21).

6. Etage de sortie selon l'une des revendications précédentes, caractérisé en ce que, entre le collecteur et la borne de sortie associée (c, d) d'un ou de deux transistors (11, 12), est montée une diode (19, 22) polarisée dans la direction de passage.

0 041 132